# EUROPEAN PATENT SPECIFICATION

(11) **EP 4 225 002 B1**
(45) Date of publication and mention of the grant of the patent: **28.10.2026**
(21) Application number: 21890659.2
(22) Date of filing: 13.07.2021
(51) Int. Cl.: H10W 40/20, H10W 40/22, H05K 7/20

(54) **HEAT DISSIPATION ASSEMBLY, ELECTRONIC DEVICE, AND CHIP PACKAGE STRUCTURE**
WÄRMEABLEITUNGSANORDNUNG, ELEKTRONISCHE VORRICHTUNG UND CHIPGEHÄUSESTRUKTUR
ENSEMBLE DE DISSIPATION DE CHALEUR, DISPOSITIF ÉLECTRONIQUE ET STRUCTURE D'ENCAPSULATION DE PUCE

(30) Priority: 10.11.2020 CN 202011244298
(43) Date of publication of application: 09.08.2023
(73) Proprietor: Huawei Technologies Co., Ltd., Shenzhen, Guangdong 518129 (CN)
(72) Inventor: LIU, Qiuzhi, Shenzhen, Guangdong 518129 (CN); YU, Fei, Shenzhen, Guangdong 518129 (CN); RAO, Chaojun, Shenzhen, Guangdong 518129 (CN); YANG, Song, Shenzhen, Guangdong 518129 (CN)
(74) Representative: Grünecker Patent- und Rechtsanwälte PartG mbB
(86) International application number: PCT/CN2021/106108
(87) International publication number: WO 2022/100128

(56) References cited:
- CN-A- 103 125 019
- CN-U- 211 088 270
- CN-Y- 201 115 145
- CN-Y- 201 230 109
- DE-A1- 102016 106 311
- JP-A- 2002 217 343
- US-A1- 2011 149 537
- US-A1- 2012 327 605
- US-A1- 2012 327 605
- US-A1- 2013 088 836
- US-A1- 2015 243 577
- US-A1- 2017 062 297
- US-A1- 2019 096 826
- US-B1- 6 191 478

## Description

### TECHNICAL FIELD

This application relates to the field of heat dissipation technologies, and in particular, to an electronic device.

### BACKGROUND

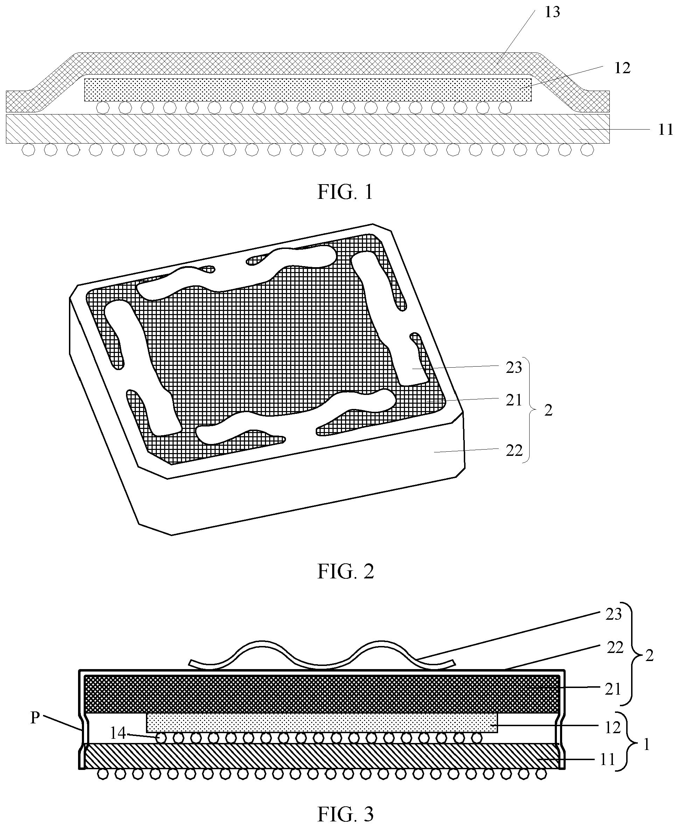

With continuous development of electronic devices, people require increasingly high chip integration, and power consumption of chips is also increasing. Consequently, chip heat dissipation is greatly limited and challenged. A chip structure may be shown in FIG. 1. A chip generally includes a substrate 11, a die 12 fastened on the substrate 11, and a protection cover 13. The protection cover 13 is bonded to the die 12 by using a heat conducting material.

In a surface mount technology (SMT) of a chip, a high temperature reflow process requires that high-temperature resistance performance and adhesion of a heat conducting material are good. However, a heat conducting material that has good adhesion and that is high-temperature resistant has a low coefficient of heat conductivity, which is generally only approximately 2 W/mK, and cannot meet a chip heat dissipation requirement. As a result, a chip heat dissipation problem is increasingly obvious.

US 2013/088836 A1 discloses a heat dissipation structure in which an IC chip that generates heat is mounted on a substrate and a heat dissipation sheet is interposed between a cover member and the IC chip to dissipate heat, wherein chip-pressing parts are provided to a cover member, so that IC chips are pressed against heat dissipation sheets by the chip-pressing parts, and each chip-pressing part is configured from an elastic pressing part equipped with an elastically deformable elastic section, and a contact section that comes into contact with a heat dissipation sheet.

### SUMMARY

This application provides an electronic device, so as to improve heat dissipation efficiency of an element. The element includes but is not limited to an electronic element, an optical element, an optoelectronic element, and the like.

According to a non-claimed example, this application provides a heat dissipation assembly of an element. The heat dissipation assembly includes a heat spreader, a frame body, and an elastic structure. The heat spreader is configured to be in contact with the element, and can evenly conduct heat generated by the element. The frame body is configured to limit a position of the heat spreader. The frame body surrounds a side wall of the heat spreader, and can prevent the heat spreader from moving in a horizontal direction, thereby avoiding damage to a heat dissipation interface caused by movement of the heat spreader. The elastic structure is fixedly connected to the frame body, and the elastic structure is located on a side that is of the heat spreader and that faces away from the to-be-contacted element. The elastic structure may be in contact with another component in an electronic device and thereby become deformed, so that the element, the heat spreader, and the frame body are reliably fastened in a thickness direction, to ensure that heat generated by the element can be smoothly conducted.

For example, the element is a chip. With the heat dissipation assembly in this embodiment of this application, in a fabrication process, a surface mount technology may be first performed on the chip, then a surface of the chip is coated with a heat conducting material, and then the heat dissipation assembly is mounted. Therefore, a requirement on adhesion strength of the heat conducting material is reduced, so that a heat conducting material with better heat dissipation performance can be selected. In this way, thermal resistance between the element and the heat dissipation assembly is small, thereby further improving heat dissipation efficiency of the chip.

In a possible implementation, at least a part of an edge of the frame body bends to an edge of a surface of the heat spreader, so that the frame body can limit a position of the heat spreader in a vertical direction. In addition, a coverage area of the frame body on the heat spreader is small, so that heat conduction performance of the heat spreader is not affected.

In a possible implementation, the frame body surrounds a side wall of the to-be-contacted element, and is configured to be clamped to the to-be-contacted element. Through this disposition, the heat spreader can be fastened on a surface of the element, so that the element, the heat spreader, and the frame body do not easily move in the horizontal direction. This further ensures stability of the heat dissipation interface between the element and the heat spreader.

In a possible implementation, an edge of a side that is of the frame body and that is farther away from the heat spreader is flush with the surface of the to-be-contacted element. Through this disposition, a contact area between the frame body and the element is large, so that clamping effect between the frame body and the element is better. In addition, the edge of the frame body does not exceed a surface of a side that is of the element and that faces away from the heat spreader, so that the frame body can be mounted in a position of the element more easily. Moreover, the frame body does not occupy an area of the element, and space around the element is sufficient for accommodating the frame body.

In a possible implementation, to increase clamping force between the frame body and the element, a protrusion structure that protrudes toward an interior may be disposed in a side wall of the frame body. The element can be hold by using the protrusion structure, so as to ensure that the frame body, the heat spreader, and the element are reliably fastened in the horizontal direction.

In a possible implementation, the protrusion structure is located on a side that is of the heat spreader and that faces away from the elastic structure. A position of the element may be limited by using the protrusion structure, so as to ensure that the element and the heat spreader do not move in the horizontal direction. In addition, in this way, the frame body can be in contact with the element for clamping more easily, and the clamping force between the frame body and the element is increased, so that the element is more unlikely to move.

In a possible implementation, protrusion structures exist in at least two opposite side walls of the frame body. For example, protrusion structures exist in all four side walls of the frame body, or protrusion structures exist in two opposite side walls of the frame body. In this way, clamping force of the frame body can be evener.

In a possible implementation, one or more protrusion structures exist in each of at least one side wall of the frame body. A quantity of protrusion structures may be set based on an actual requirement, so that effect of clamping the frame body to the heat spreader and the element is better.

In a possible implementation, elastic structures are disposed at at least two opposite edges of the frame body. For example, elastic structures may be disposed at edges of all sides of the frame body, or elastic structures may be disposed at edges of two opposite sides of the frame body. In this way, after the elastic structure is deformed under compression, elastic force applied to the heat spreader and the element can be evener.

In a possible implementation, the elastic structure may be configured as a spring plate, and the elastic structure has at least one protruding portion, where the protruding portion protrudes toward a side facing away from the heat spreader. In this way, when the elastic structure is deformed under compression, elastic force can be generated, so that the heat spreader and the element can come into tight contact with each other.

In a possible implementation, the protruding portion may be configured as arc-shaped. In this way, the elastic structure can be deformed more easily, and elasticity of the elastic structure is good.

In a possible implementation, to increase an elastic capability of the elastic structure, the elastic structure may be configured as having two symmetrically disposed protruding portions. In addition, the elastic structure may be configured as an integrated structure, so that elasticity of the elastic structure is good.

In a possible implementation, the protruding portion is strip-shaped, and an extension direction of the protruding portion is the same as an extension direction of an edge of the heat spreader, or a specific included angle exists between an extension direction of the protruding portion and an extension direction of an edge of the heat spreader. When the protruding portion is disposed in either of these two manners, an area that is of the heat spreader and that is occupied by the protruding portion can be small, so that heat dissipation effect of the element is not affected. The extension direction of the protruding portion may be set based on a specific structure of the element, so as to dissipate heat of the element more effectively.

In a possible implementation, a material of the elastic structure may include an elastic plastic material or a metallic material. For example, the elastic structure may be fabricated as an elastic thin steel sheet or a sheet metal part, so that the elastic structure can have good elasticity.

In a possible implementation, a shape of the heat spreader is the same as a shape of a contour of the to-be-contacted element, and a size of the heat spreader is the same as a size of the contour of the element. In this way, a heat dissipation area of the heat spreader can be large, thereby improving heat dissipation efficiency of the element. In addition, this makes it easier for the frame body to limit the position of the heat spreader, so that clamping effect between the frame body and the element is better.

In a possible implementation, a material of the heat spreader may include a metallic material. For example, the heat spreader may be made of a material with high heat conductivity, such as copper, iron, or aluminum. A metallic material has a strong heat conduction capability. Therefore, when the heat spreader is made of a metallic material, heat of the element can be quickly conducted, thereby improving heat dissipation efficiency of the element.

In a possible implementation, the frame body and the elastic structure may be an integrated structure. In this way, the elastic structure and the frame body can be connected more firmly. During fabrication, the frame body and the elastic structure can be directly formed through a same process, thereby reducing fabrication costs.

In a possible implementation, the frame body is a detachable structure. In this way, a manner of fastening the frame body, the heat spreader, and the element can be simple.

According to the invention, this application provides an electronic device according to claim 1. The electronic device includes an element and the heat dissipation assembly described above, and the element is in contact with a heat spreader in the heat dissipation assembly. In the electronic device provided in this embodiment of this application, the heat dissipation assembly is mounted in a position of the element, so that heat generated by the element can be conducted through the heat dissipation assembly, thereby improving heat dissipation efficiency of the electronic device. The element includes but is not limited to an electronic element, an optical element, an optoelectronic element, and the like.

The electronic device further includes a bottom housing, an upper cover fixedly connected to the bottom housing, and a printed circuit board. The bottom housing and the upper cover enclose space that can accommodate the printed circuit board, the element, and the heat dissipation assembly. The printed circuit board is disposed in the bottom housing. The element is fastened on a side that is of the printed circuit board and that faces away from the bottom housing. A heat dissipation boss is disposed on a side of the upper cover closer to the bottom housing. An elastic structure in the heat dissipation assembly is in contact with the heat dissipation boss, and the elastic structure is deformed. The heat dissipation assembly is mounted in the position of the element, a surface of one side of the heat spreader is in contact with the element, a surface of the other side of the heat spreader is in contact with the elastic structure, and the elastic structure is in contact with the heat dissipation boss. In addition, the elastic structure is deformed to a specific extent, so that the element, the heat spreader, and the frame body are reliably fastened in a thickness direction. In this way, heat generated by the element can be evenly conducted through the heat spreader and the heat dissipation boss.

Space between the heat dissipation boss and the heat spreader is filled with a first heat conducting material. For example, the first heat conducting material may be thermal gel.

In a possible implementation, the heat spreader is in contact with the element through a second heat conducting material. Because the heat dissipation assembly has a low requirement on adhesion strength of a heat conducting material, a heat conducting material with a good heat dissipation capability can be selected as the second heat conducting material. For example, a material of the second heat conducting material may include a silicone material, whose coefficient of heat conductivity is approximately 6 W/mK, thereby improving heat dissipation efficiency of the element.

According to another non-claimed example, to resolve a problem that a protection cover occupies a layout area of a chip package, this application further provides a chip package structure. The chip package structure may include a substrate, a die fastened on the substrate, and a cover plate. An edge of the die is located within a range of an edge of the substrate, so as to allow sufficient space for packaging. The cover plate is located on a side that is of the die and that faces away from the substrate. The cover plate has a supporting column on a side closer to the substrate. The supporting column is fastened at an edge of the cover plate. The substrate is provided with a notch in a position corresponding to the supporting column. For example, the notch may be a quarter-round hole, a half-round hole, or the like. The supporting column is fixedly connected to the substrate through an inner surface of the notch.

In the chip package structure provided in this embodiment of this application, the cover plate with the supporting column is disposed, the substrate is provided with the notch in the position corresponding to the supporting column, and the supporting column is fixedly connected to the substrate through the inner surface of the notch. Therefore, the cover plate does not occupy an area of an element, and a layout area of an element package is increased.

In a possible implementation, a surface of a side that is of the supporting column and that faces away from the cover plate is flush with a surface of a side that is of the substrate and that faces away from the cover plate. Through this disposition, a gap between the die and the cover plate can be controlled by using the supporting column, so as to avoid a case that thermal resistance between the element and the cover plate is increased due to an excessively large gap, and avoid a case that the element is squeezed due to an excessively small gap.

In a possible implementation, the inner surface of the notch of the substrate has a metal layer. For example, copper plating may be disposed in the notch of the substrate. Therefore, the supporting column may be welded to the inner surface of the notch through the metal layer, so that a connection between the supporting column and the substrate is firmer.

In a possible implementation, the supporting column has a fastening portion that protrudes toward an interior, and the fastening portion is in contact with a surface of a side of the substrate closer to the cover plate. This can enhance a supporting capability of the supporting column, and ensure that a specific gap is kept between the die and the cover plate.

In a possible implementation, space between the die and the cover plate is filled with a third heat conducting material, to improve heat dissipation efficiency of the chip package structure.

### BRIEF DESCRIPTION OF DRAWINGS

FIG. 1 is a schematic diagram of a structure of a chip in a related technology;
FIG. 2 is a schematic diagram of a three-dimensional structure of a heat dissipation assembly according to an embodiment of this application;
FIG. 3 is a schematic diagram of mounting a heat dissipation assembly in a position of an element according to an embodiment of this application;
FIG. 4 is a schematic diagram of applying a heat dissipation assembly to an optical module according to an embodiment of this application;
FIG. 5 is a schematic top view of a structure of a heat dissipation assembly according to an embodiment of this application;
FIG. 6 is a schematic cross-sectional view of FIG. 5 at a dashed line L;
FIG. 7 is another schematic top view of a structure of a heat dissipation assembly according to an embodiment of this application;
FIG. 8 is a side view of the heat dissipation assembly corresponding to FIG. 7;
FIG. 9 is another schematic top view of a structure of a heat dissipation assembly according to an embodiment of this application;
FIG. 10 is a side view of the heat dissipation assembly corresponding to FIG. 9;
FIG. 11 is another schematic top view of a structure of a heat dissipation assembly according to an embodiment of this application;
FIG. 12 is a side view of the heat dissipation assembly corresponding to FIG. 11;
FIG. 13 is another schematic top view of a structure of a heat dissipation assembly according to an embodiment of this application;
FIG. 14 is a side view of the heat dissipation assembly corresponding to FIG. 13;
FIG. 15 is another schematic top view of a structure of a heat dissipation assembly according to an embodiment of this application;
FIG. 16 is a side view of the heat dissipation assembly corresponding to FIG. 15;
FIG. 17 is a schematic diagram of a structure of an electronic device that is an optical module;
FIG. 18 is a side view of a chip package structure according to an embodiment of this application;
FIG. 19 is a schematic plan view of a structure of a chip package structure according to an embodiment of this application;
FIG. 20 is a schematic diagram of a three-dimensional structure of a chip package structure according to an embodiment of this application; and
FIG. 21 is another schematic diagram of a three-dimensional structure of a chip package structure according to an embodiment of this application.

### Reference signs are listed as follows:

1: element; 11: substrate; 12: die; 13: protection cover; 14: second welding layer; 15: first welding layer; 2: heat dissipation assembly; 21: heat spreader; 22: frame body; 23: elastic structure; 231: protruding portion; P: protrusion structure; 31: bottom housing; 32: upper cover; 33: printed circuit board; 34: heat dissipation boss; 35: optical component; T1: first bolt; T2: second bolt; 4: cover plate; 41: supporting column; 411: fastening portion; U: notch.

### DESCRIPTION OF EMBODIMENTS

To make the objectives, technical solutions, and advantages of this application clearer, the following further describes this application in detail with reference to the accompanying drawings.

To facilitate understanding of a heat dissipation assembly of an element provided in embodiments of this application, an application scenario of the heat dissipation assembly is first described. The heat dissipation assembly in this application may dissipate heat for various elements, so that the various elements work in a non-high-temperature environment, thereby avoiding burnout of the elements and maintaining lifespans of the elements. The elements include but are not limited to an electronic element, an optical element, an optoelectronic element, and the like. For example, the element may be a chip, for example, may be any type of chip such as a radio frequency integrated chip or a driver chip. Certainly, the element in this application may alternatively be another component. In some embodiments, the heat dissipation assembly may also be applied to an optical module. For example, the heat dissipation assembly may be disposed in a position of a chip in the optical module. Disposing the heat dissipation assembly in the optical module can effectively resolve a heat dissipation problem of the chip with high heat density in the optical module. In addition, the heat dissipation assembly may also be applied to an electronic device such as a mobile phone, a tablet computer, or a notebook computer, to improve heat dissipation efficiency of the electronic device.

For example, the element is a chip. Because a requirement on chip integration is increasingly high, generally a chip may have a plurality of functions such as data exchange, control, and digital-analog conversion, and power consumption of a chip is also increasing. Consequently, chip heat dissipation is greatly limited and challenged. In a surface mount technology of a chip, a high temperature reflow process requires that high-temperature resistance performance and adhesion of a heat conducting material be high. However, a heat conducting material that has good adhesion and that is high-temperature resistant has a low coefficient of heat conductivity, which is generally only approximately 2 W/mK, and cannot meet a chip heat dissipation requirement. As a result, a chip heat dissipation problem is increasingly obvious.

Based on this, to resolve the chip heat dissipation problem, embodiments of this application provide a heat dissipation assembly, an electronic device, and a package structure.

It should be noted that, in this specification, similar reference numerals and letters in the following accompanying drawings represent similar items. Therefore, once an item is defined in an accompanying drawing, the item does not need to be further defined or interpreted in following accompanying drawings.

In descriptions of this application, it should be noted that orientation or location relationships indicated by terms "center", "above", "below", "left", "right", "vertical", "horizontal", "inner", "outer", and the like are orientation or location relationships based on the accompanying drawings, and are merely intended for case of describing this application and simplifying description, rather than indicating or implying that an apparatus or element in question needs to have a specific orientation or needs to be constructed and operated in a specific orientation. Therefore, such terms cannot be construed as a limitation on this application. In addition, terms "first" and "second" are merely used for a purpose of description, and shall not be construed as an indication or implication of relative importance.

In descriptions of this application, it should be noted that unless otherwise expressly specified and limited, terms "mount", "interconnect", and "connect" should be understood in a broad sense. For example, such terms may indicate a fixed connection, a detachable connection, or an integral connection; may indicate a mechanical connection or an electrical connection; and may indicate direct interconnection, indirect interconnection through an intermediate medium, or internal communication between two elements. A person of ordinary skill in the art may understand specific meanings of the foregoing terms in this application based on a specific situation.

FIG. 2 is a schematic diagram of a three-dimensional structure of a heat dissipation assembly 2 according to an embodiment of this application. As shown in FIG. 2, the heat dissipation assembly 2 may include: a heat spreader 21, configured to be in contact with an element 1; a frame body 22, configured to limit a position of the heat spreader 21, where the frame body 22 surrounds a side wall of the heat spreader 21; and an elastic structure 23, fixedly connected to the frame body 22, where the elastic structure 23 is located on a side that is of the heat spreader 21 and that faces away from the to-be-contacted element 1.

In the heat dissipation assembly provided in this embodiment of this application, the heat spreader configured to be in contact with the element is disposed, so that heat generated by the element can be evenly conducted; the frame body is disposed, so that the position of the heat spreader can be limited, thereby preventing the heat spreader from moving in a horizontal direction, and avoiding impact on heat dissipation performance caused by damage to a heat dissipation interface due to movement of the heat spreader; furthermore, the elastic structure fixedly connected to the frame body is disposed, and the elastic structure may be in contact with another component in an electronic device and become deformed, so that the element, the heat spreader, and the frame body are reliably fastened in a thickness direction, to ensure that heat generated by the element can be smoothly conducted. Moreover, in a fabrication process, the surface mount technology may be first performed on the chip, a surface of the chip is coated with a heat conducting material, and then the heat dissipation assembly is mounted. Therefore, a requirement on adhesion strength of the heat conducting material is reduced, so that a heat conducting material with better heat dissipation performance can be selected. In this way, thermal resistance between the element and the heat dissipation assembly is small, and heat dissipation efficiency of the chip is further improved.

In a related technology, refer to FIG. 1. The die 12 and the protection cover 13 are bonded to each other through a heat conducting material, and heat generated by the die 12 is conducted through the heat conducting material and the protection cover 13. However, in the surface mount technology, a high temperature reflow process requires that high-temperature resistance performance and adhesion of a heat conducting material are good, but a heat conducting material that has good adhesion and that is high-temperature resistant has a low coefficient of heat conductivity, which is generally only approximately 2 W/mK, and cannot meet a chip heat dissipation requirement. Experiments prove that, compared with the solution in which the protection cover 13 is bonded on the die 12 in the related technology shown in FIG. 1, in this embodiment of this application, with the heat dissipation assembly disposed, a heat dissipation gain of the element can reach 7°C to 11°C, and power consumption of the element is also reduced to some extent, thereby improving performance of the element.

In this embodiment of this application, the heat dissipation assembly is described by using an example in which the element is the chip. In actual application, the heat dissipation assembly may also dissipate heat for another element, and an application scenario of the heat dissipation assembly may be selected based on an actual requirement. The element is not limited in this application.

FIG. 3 is a schematic diagram of mounting a heat dissipation assembly in a position of an element 1 according to an embodiment of this application. With reference to FIG. 2 and FIG. 3, a surface of one side of the heat spreader 21 is in contact with the element 1, to conduct heat generated by the element 1. To achieve balanced heat conduction effect of the heat spreader 21, the heat spreader 21 may be configured as having a uniform thickness. For example, the thickness of the heat spreader 21 may be set to approximately 2 mm. A specific thickness of the heat spreader 21 may be set based on pressure resistance and reliability of the element 1. The thickness of the heat spreader 21 is not limited herein. The elastic structure 23 is located on the side that is of the heat spreader 21 and that faces away from the element 1. After the elastic structure 23 is deformed, the element 1, the heat spreader 21, and the frame body 22 can be fastened in positions in the thickness direction, so that heat generated by the element 1 can be conducted to the heat spreader 21. In addition, the frame body 22 can limit the position of the heat spreader 21, thereby preventing the heat spreader 21 from moving in the horizontal direction. Therefore, after the heat dissipation assembly 2 is mounted in the position of the element 1, the heat spreader 21 does not move in the horizontal direction or the thickness direction. This ensures that the heat dissipation interface is stable, so that heat generated by the element 1 is smoothly conducted. In addition, the elastic structure 23 may be located at an edge of a side that is of the frame body 22 and that is closer to the heat spreader 21. Therefore, a coverage area of the elastic structure 23 on the heat spreader 21 is small, so that heat conduction performance of the heat spreader 21 is not affected.

Optionally, in this application, as shown in FIG. 2 and FIG. 3, the elastic structure 23 may be in contact with the heat spreader 21, in other words, the elastic structure 23 is located on an inner side of the frame body 22. In this way, space occupied by the heat dissipation assembly is small, which is more conducive to proper utilization of space. Certainly, the elastic structure 23 may alternatively not be in contact with the heat spreader 21. For example, the elastic structure 23 may be located on an outer side of the frame body 22. A specific position of the elastic structure 23 is not limited herein, provided that the element 1, the heat spreader 21, and the frame body 22 can be fastened in the positions in the thickness direction after the elastic structure 23 is deformed.

Refer to FIG. 3. To further improve heat dissipation effect, space between the heat spreader 21 and the element 1 may be filled with a heat conducting material. Because the heat dissipation assembly 2 has a low requirement on adhesion strength of a heat conducting material, a heat conducting material with a good heat dissipation capability can be selected. For example, the heat conducting material may be a silicone material, whose coefficient of heat conductivity is approximately 6 W/mK, thereby improving heat dissipation efficiency of the element 1. In addition, to avoid impact on heat conduction from the element 1 to the heat spreader 21 caused by an excessively large distance between the element 1 and the heat spreader 21, a gap between the element 1 and the heat spreader 21 may be set to be less than 0.1 mm, for example, may be set to 0.05 mm, in other words, a thickness of the heat conducting material disposed between the element 1 and the heat spreader 21 is less than 0.1 mm.

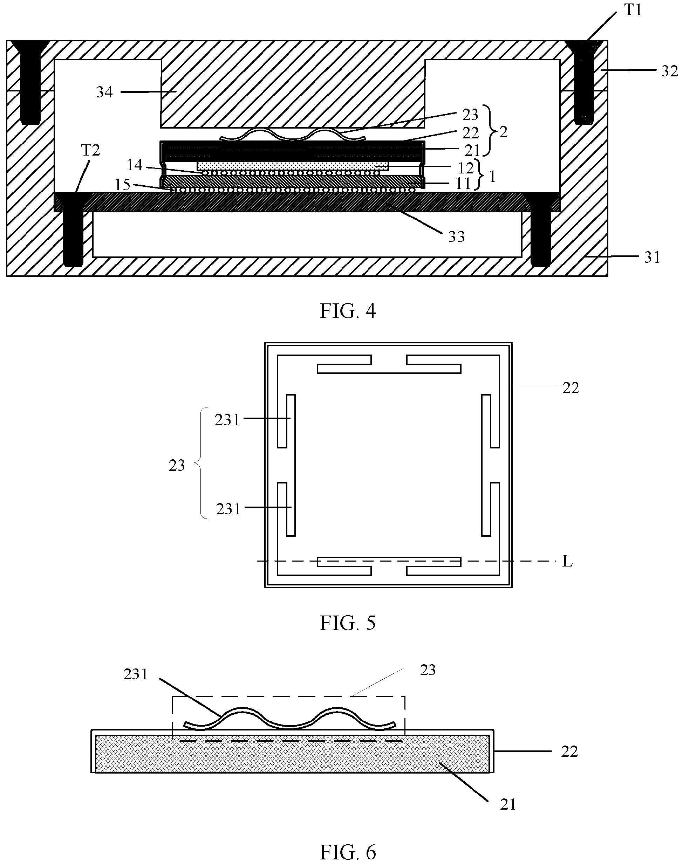

FIG. 4 is a schematic diagram of applying a heat dissipation assembly to an optical module according to an embodiment of this application. As shown in FIG. 4, the optical module may include a bottom housing 31, an upper cover 32 fixedly connected to the bottom housing 31, and a printed circuit board 33. The upper cover 32 includes a heat dissipation boss 34. The bottom housing 31 and the upper cover 32 enclose space that can accommodate the printed circuit board 33, an element 1, and the heat dissipation assembly 2. Optionally, the bottom housing 31 may be fixedly connected to the upper cover 32 by using a first bolt T1, and the printed circuit board 33 is disposed on the bottom housing 31. Optionally, the printed circuit board 33 may be fixedly connected to the bottom housing 31 by using a second bolt T2. Certainly, the printed circuit board 33 may be alternatively disposed in the bottom housing 31 in another manner, which is not limited herein. The element 1 is fastened on the printed circuit board 33. Optionally, the element 1 may be fastened on the printed circuit board 33 through a first welding layer 15. The heat dissipation assembly 2 is mounted in a position of the element 1, where a surface of one side of a heat spreader 21 is in contact with the element 1, and an elastic structure 23 is in contact with the heat dissipation boss 34. In addition, the elastic structure 23 is deformed to a specific extent, so that the element 1, the heat spreader 21, and a frame body 22 are reliably fastened in a thickness direction. In this way, heat generated by the element 1 can be evenly conducted through the heat spreader 21 and the heat dissipation boss 34.

FIG. 5 is a schematic top view of a structure of a heat dissipation assembly according to an embodiment of this application. As shown in FIG. 2 and FIG. 5, in some embodiments, at least a part of an edge of the frame body 22 bends to an edge of a surface of the heat spreader 21. In this way, the frame body 22 can limit a position of the heat spreader 21 in a vertical direction. In addition, as the edge of the frame body 22 is bent to the edge of the surface of the heat spreader 21, a coverage area of the frame body 22 on the heat spreader 21 is small, so that heat conduction performance of the heat spreader 21 is not affected. FIG. 6 is a schematic cross-sectional view of FIG. 5 at a dashed line L. As shown in FIG. 6, the frame body 22 surrounds the heat spreader 21, and the frame body 22 is in contact with the heat spreader 21, so that a position of the heat spreader 21 in a horizontal direction can be limited.

Further, in the heat dissipation assembly provided in this embodiment of this application, refer to FIG. 3. The frame body 22 surrounds a side wall of the to-be-contacted element 1, and is configured to be clamped to the to-be-contacted element 1. In this way, the heat spreader 21 can be fastened on a surface of the element 1, so that the element 1, the heat spreader 21, and the frame body 22 do not easily move in the horizontal direction. This further ensures stability of the heat dissipation interface between the element 1 and the heat spreader 21. To implement clamping between the frame body 22 and the element 1, the frame body 22 may be in contact with at least a part of the side wall of the element 1.

Refer to FIG. 3. In this embodiment of this application, an edge of a side that is of the frame body 22 and that is farther away from the heat spreader 21 is flush with the surface of the to-be-contacted element 1. In this way, a contact area between the frame body 22 and the element 1 is large, so that the frame body 22 is clamped to the element 1 more easily, and the heat spreader 21 can be fastened to the surface of the element 1 more firmly. In addition, the edge of the side that is of the frame body 22 and that is farther away from the heat spreader 21 does not exceed a surface of a side that is of the element 1 and that faces away from the heat spreader 21, so that the frame body 22 can be mounted in the position of the element 1 more easily. Furthermore, the frame body 22 does not occupy an area of the element 1, so that an original structure of the element 1 does not need to be changed, and space around the element 1 is sufficient for accommodating the frame body 22. Therefore, the heat dissipation assembly in this application can also be applied to an element 1 with a small size, thereby resolving a problem in a related technology that a heat dissipation component cannot be disposed in an element 1 with a small size due to insufficient space.

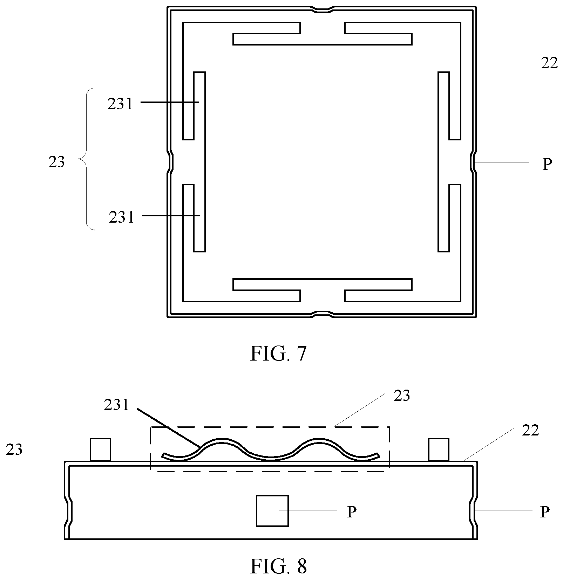

FIG. 7 is another schematic top view of a structure of a heat dissipation assembly according to an embodiment of this application. FIG. 8 is a side view of the heat dissipation assembly corresponding to FIG. 7. As shown in FIG. 7 and FIG. 8, a protrusion structure P that protrudes toward an interior exists in a side wall of a frame body 22. In this way, an element 1 can be hold by using the protrusion structure P, so that clamping force between the frame body 22 and the element 1 is larger, thereby ensuring that the frame body 22, a heat spreader 21, and the element 1 are reliably fastened in a horizontal direction, and further ensuring stability of a heat dissipation interface between the element 1 and the heat spreader 21.

Optionally, in the heat dissipation assembly provided in this embodiment of this application, as shown in FIG. 3, the protrusion structure P is located on a side that is of the heat spreader 21 and that faces away from the elastic structure 23. Because the elastic structure 23 is fastened to the edge of the side that is of the frame body 22 and that is closer to the heat spreader 21, the position of the heat spreader 21 can be limited at least in a position in which the elastic structure 23 is in contact with the frame body 22. Therefore, the protrusion structure P is disposed on the side that is of the heat spreader 21 and that faces away from the elastic structure 23, so that the position of the element 1 can be further limited by using the protrusion structure P, thereby further ensuring that the element 1 and the heat spreader 21 do not move in the horizontal direction. In addition, an example in which the element 1 is a chip is used. The element 1 may include a substrate 11 and a die 12. The die 12 is fastened on the substrate 11 through a second welding layer 14. Generally, a size of the die 12 is less than a size of the substrate 11. With the protrusion structure P disposed in a position of a side wall of the element 1, the frame body 22 can be in contact with the element 1 for clamping more easily, and moreover, the clamping force between the frame body 22 and the element 1 can be increased, so that the element 1 is more unlikely to move. In addition, the protrusion structure P may be alternatively disposed in a position corresponding to the heat spreader 21. A specific position of the protrusion structure P is not limited herein. The die 12 may be a die, and is a small block of an integrated circuit body that is made of a semiconductor material and that is unpackaged, and a given function of the integrated circuit is implemented on this small piece of semiconductor.

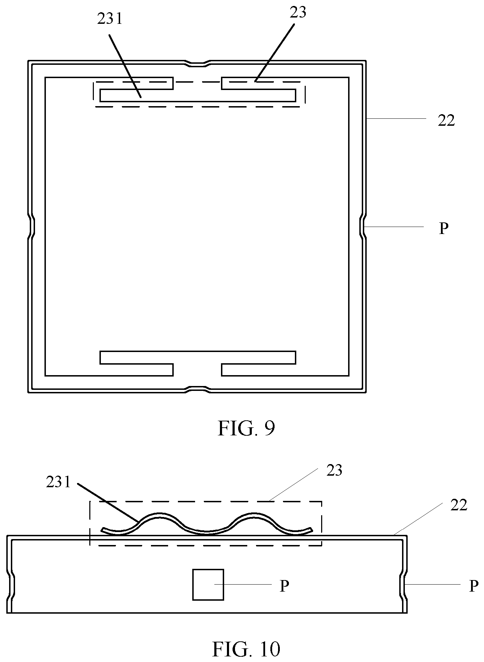

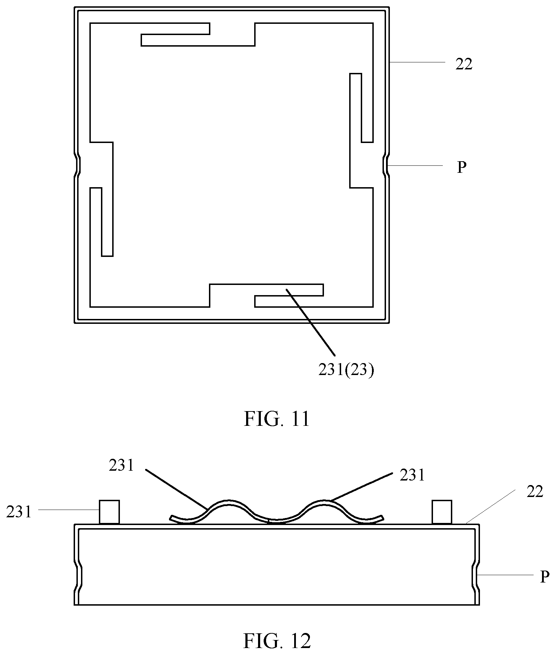

FIG. 9 is another schematic top view of a structure of a heat dissipation assembly according to an embodiment of this application. FIG. 10 is a side view of the heat dissipation assembly corresponding to FIG. 9. As shown in FIG. 9 and FIG. 10, protrusion structures P exist in at least two opposite side walls of a frame body 22. For example, in the heat dissipation assembly shown in FIG. 9, protrusion structures P exist in all four side walls of the frame body 22. FIG. 11 is another schematic top view of a structure of a heat dissipation assembly according to an embodiment of this application. FIG. 12 is a side view of the heat dissipation assembly corresponding to FIG. 11. In FIG. 11 and FIG. 12, protrusion structures P exist in two opposite side walls of a frame body 22. In this way, clamping force of the frame body 22 can be evener, thereby avoiding relative movement between an element 1 and a heat spreader 21 caused by uneven clamping force of the frame body 22.

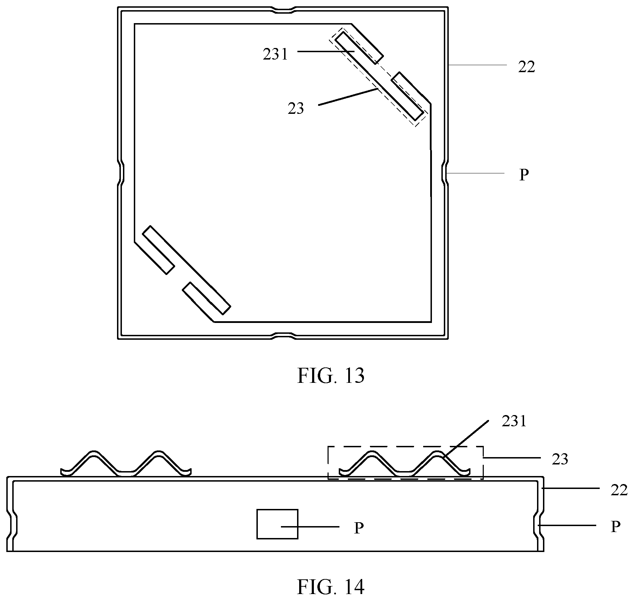

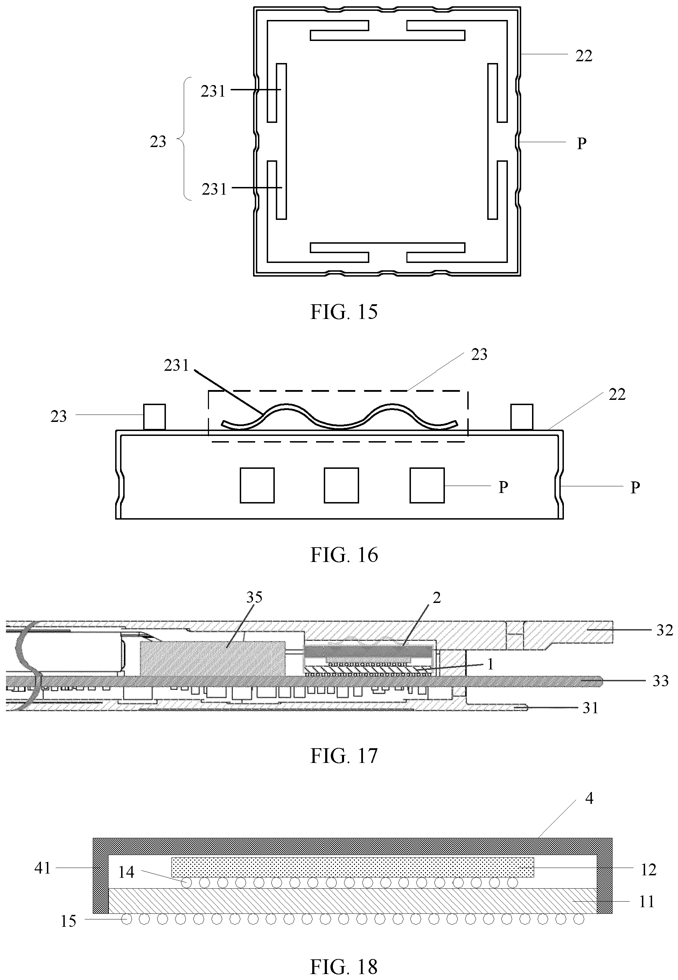

Optionally, in embodiments of this application, one or more protrusion structures P exist in each of at least one side wall of the frame body 22. FIG. 13 is another schematic top view of a structure of a heat dissipation assembly according to an embodiment of this application. FIG. 14 is a side view of the heat dissipation assembly corresponding to FIG. 13. As shown in FIG. 13 and FIG. 14, one protrusion structure P may exist in each of at least one side wall of a frame body 22. FIG. 15 is another schematic top view of a structure of a heat dissipation assembly according to an embodiment of this application. FIG. 16 is a side view of the heat dissipation assembly corresponding to FIG. 15. As shown in FIG. 15 and FIG. 16, alternatively, a plurality of protrusion structures P may exist in each of at least one side wall of a frame body 22. In this way, clamping force of the frame body 22 can be large, thereby achieving better effect of clamping the frame body 22 to a heat spreader 21 and an element 1, so that the heat spreader 21 and the element 1 are more unlikely to move. In FIG. 15 and FIG. 16, an example in which three protrusion structures P exist in one side wall of the frame body 22 is used for illustration, and a quantity of protrusion structures P is not limited. In addition, in FIG. 7 to FIG. 16, an example in which the protrusion structure P is close to a central region in the side wall of the frame body 22 is used for illustration. In actual application, a position of the protrusion structure P may be set based on an actual requirement. The position of the protrusion structure P is not limited herein.

In all the accompanying drawings of this application, limited quantities of protrusion structures P and elastic structures 23 are used as an example for illustration, which does not impose a limitation on quantities of protrusion structures P and elastic structures 23. In addition, in all the accompanying drawings of this application, an example in which the protrusion structure P is square is used for illustration. In actual application, the protrusion structure P may be alternatively configured as round, trapezoidal, or in another shape. A shape of the protrusion structure P is not limited herein.

Optionally, in the heat dissipation assembly in embodiments of this application, as shown in FIG. 5, elastic structures 23 are disposed at at least two opposite edges of the frame body 22. In this way, after the elastic structures 23 are deformed under compression, elastic force applied to the heat spreader 21 and the element 1 is evener, thereby avoiding relative movement caused by uneven elastic force applied to the heat spreader 21 and the element 1. For example, in FIG. 5 and FIG. 6, elastic structures 23 are disposed at edges of all sides of the frame body 22; as shown in FIG. 9 and FIG. 10, elastic structures 23 are disposed at edges of two opposite sides of the frame body 22.

In an embodiment of this application, as shown in FIG. 5 and FIG. 6, the elastic structure 23 is a spring plate.

The elastic structure 23 has at least one protruding portion 231. The protruding portion 231 protrudes toward a side facing away from the heat spreader 21.

The elastic structure 23 is configured as a spring plate and is provided with at least one protruding portion 231, so that when the elastic structure 23 is deformed under compression, elastic force can be generated, and the heat spreader 21 and the element 1 can come into tight contact with each other. In addition, one end of the protruding portion 231 may be fastened, whereas the other end is movable, so that when the protruding portion 231 is compressed, the movable end can slide on a surface of the heat spreader 21, and when the protruding portion 231 is not compressed, the movable end can be restored to an initial state. In this way, an elastic capability of the elastic structure 23 is strong.

Optionally, in the heat dissipation assembly in embodiments of this application, as shown in FIG. 6, the protruding portion 231 may be arc-shaped. In this way, the elastic structure 23 can be deformed more easily, and elasticity of the elastic structure 23 is good.

In some embodiments, in the heat dissipation assembly provided in embodiments of this application, as shown in FIG. 5, the elastic structure 23 has two symmetrically disposed protruding portions 231, thereby increasing an elastic capability of the elastic structure 23. Fastened ends of the two protruding portions 231 may be connected, so that the other ends of the two protruding portions 231 are still movable. For example, the elastic structure 23 may be configured as an integrated structure, so that elasticity of the elastic structure 23 is good. As shown in FIG. 11 and FIG. 12, the elastic structure 23 may alternatively have one protruding portion 231. It should be noted that, because FIG. 12 is the side view of FIG. 11, there are two protruding portions 231 in FIG. 12, and the two protruding portions 231 do not belong to a same elastic structure. Certainly, the elastic structure 23 may alternatively have more protruding portions 231. A quantity of protruding portions 231 in the elastic structure 23 is not limited herein.

Optionally, in the heat dissipation assembly in embodiments of this application, as shown in FIG. 5, the protruding portion 231 may be strip-shaped.

As shown in FIG. 5 and FIG. 6, an extension direction of the protruding portion 231 is the same as an extension direction of an edge of the heat spreader 21. Alternatively, as shown in FIG. 13 and FIG. 14, a specific included angle exists between an extension direction of the protruding portion 231 and an extension direction of an edge of the heat spreader 21. When the protruding portion 231 is disposed in either of these two manners, an area that is of the heat spreader and that is occupied by the protruding portion 231 is small, so that heat dissipation effect of the element is not affected. In actual application, the extension direction of the protruding portion 231 may be set based on a specific structure of the element, so as to dissipate heat of the element more effectively.

In some embodiments of this application, a material of the elastic structure may include an elastic plastic material or a metallic material. When the elastic structure is made of an elastic plastic material or a metallic material, the elastic structure can have good elasticity. For example, the elastic structure may be fabricated as an elastic thin steel sheet or a sheet metal part. Certainly, the elastic structure may be alternatively made of another elastic material. For example, the elastic structure may be alternatively made of a plastic material. This is not limited herein.

Optionally, in the heat dissipation assembly provided in embodiments of this application, as shown in FIG. 3, a shape of the heat spreader 21 is the same as a shape of a contour of the to-be-contacted element 1, and a size of the heat spreader 21 is the same as a size of the contour of the element 1.

It should be noted that the contour of the element 1 herein may be understood as a shape enclosed by outermost edges of the element 1. An example in which the element 1 is a chip is used. A size of the substrate 11 in the element 1 is greater than a size of the die 12, and therefore, the contour of the element 1 may be a contour of the substrate 11.

The shape and size of the heat spreader 21 are set to be the same as the shape and size of the contour of the element 1. In this way, a heat dissipation area of the heat spreader 21 can be large, thereby improving heat dissipation efficiency of the element 1. In addition, this makes it easier for the frame body 22 to limit the position of the heat spreader 21, and also achieves better clamping effect between the frame body 22 and the element 1, so that the heat spreader 21 and the element 1 do not easily move, thereby ensuring stability of the heat dissipation interface between the heat spreader 21 and the element 1.

In some embodiments, in the heat dissipation assembly provided in embodiments of this application, a material of the heat spreader may include a metallic material. A metallic material has a strong heat conduction capability. When the heat spreader is made of a metallic material, heat of the element can be quickly conducted, thereby improving heat dissipation efficiency of the element. For example, the heat spreader may be made of a material with high heat conductivity, such as copper, iron, or aluminum. Certainly, the heat spreader may be alternatively made of another material with a strong heat conduction capability. The material of the heat spreader is not limited herein. In embodiments of this application, because the gap between the heat spreader and the element is small, for example, may be set to be less than 0.1 mm, and a heat conduction capability of the heat spreader is strong, for example, heat conductivity of the heat spreader can reach 400 W/mK when the heat spreader is made of copper, heat generated by the element can be evenly and quickly conducted.

Optionally, in embodiments of this application, refer to FIG. 3. The frame body 22 and the elastic structure 23 may be an integrated structure. In this way, the elastic structure 23 and the frame body 22 can be connected more firmly. Moreover, during fabrication, the frame body 22 and the elastic structure 23 can be directly formed through a same process, thereby reducing fabrication steps and reducing fabrication costs. Certainly, the elastic structure 23 and the frame body 22 may alternatively be two discrete components, in which case the elastic structure 23 is fastened in a position of an edge of the frame body 22 in a manner such as welding or bonding. A specific manner of disposing the frame body 22 and the elastic structure 23 is not limited herein.

In some embodiments, in the heat dissipation assembly provided in embodiments of this application, the frame body is a detachable structure. In a fabrication process, a surface mount technology may be first performed on the chip, then a surface of the chip is coated with a heat conducting material, and then the heat dissipation assembly is mounted. Therefore, a requirement on adhesion strength of the heat conducting material is reduced, so that a heat conducting material with better heat dissipation performance can be selected, thereby further improving heat dissipation efficiency of the chip. In addition, when the frame body is disposed as a detachable structure, a manner of fastening the frame body, the heat spreader, and the element is simple.

Based on a same technical idea, an embodiment of this application further provides an electronic device. As shown in FIG. 17, the electronic device includes an element 1 and any heat dissipation assembly 2 described above. The element 1 is in contact with a heat spreader in the heat dissipation assembly 2. In the electronic device provided in this embodiment of this application, the heat dissipation assembly is mounted in a position of the element, so that heat generated by the element can be conducted through the heat dissipation assembly, thereby improving heat dissipation efficiency of the electronic device. The element includes but is not limited to an electronic element, an optical element, an optoelectronic element, and the like.

In FIG. 17, an example in which the electronic device is an optical module is used for illustration. The optical module is an active optoelectronic component implementing optical-to-electrical conversion and electrical-to-optical conversion, and is an important functional module of an optical communication device. As shown in FIG. 17, the electronic device may further include an optical component 35. In this application, the example in which the electronic device is the optical module is used for description. Certainly, the electronic device may alternatively be another device that needs heat dissipation, and the heat dissipation assembly only needs to be mounted in a position of an element that needs heat dissipation in the electronic device. A type of the electronic device is not limited herein.

In this embodiment of this application, refer to FIG. 4. The electronic device may further include a bottom housing 31, an upper cover 32 fixedly connected to the bottom housing 31, and a printed circuit board 33. The printed circuit board 33 is disposed in the bottom housing 31. The element 1 is fastened on a side that is of the printed circuit board 33 and that faces away from the bottom housing 31. A heat dissipation boss 34 is disposed on a side of the upper cover 32 closer to the bottom housing 31. An elastic structure 23 in the heat dissipation assembly 2 is in contact with the heat dissipation boss 34, and the elastic structure 23 is deformed.

The bottom housing 31 and the upper cover 32 enclose space that can accommodate the printed circuit board 33, the element 1, and the heat dissipation assembly 2. Optionally, the bottom housing 31 may be fixedly connected to the upper cover 32 by using a first bolt T1, and the printed circuit board 33 may be fixedly connected to the bottom housing 31 by using a second bolt T2. Alternatively, the printed circuit board 33 may be disposed in the bottom housing 31 in another manner, which is not limited herein. The element 1 is fastened on the printed circuit board 33. Optionally, the element 1 may be fastened on the printed circuit board 33 through a first welding layer 15. The heat dissipation assembly 2 is mounted in the position of the element 1, where a surface of one side of the heat spreader 21 is in contact with the element 1, a surface of the other side of the heat spreader is in contact with the elastic structure 23, and the elastic structure 23 is in contact with the heat dissipation boss 34. In addition, the elastic structure 23 is deformed to a specific extent, so that the element 1, the heat spreader 21, and a frame body 22 are reliably fastened in a thickness direction. In this way, heat generated by the element 1 can be evenly conducted through the heat spreader 21 and the heat dissipation boss 34.

In some embodiments, in the electronic device provided in this embodiment of this application, refer to FIG. 4. Space between the heat dissipation boss 34 and the heat spreader 21 is filled with a first heat conducting material (not shown in the figure). For example, the first heat conducting material may be thermal gel. A gap between the heat dissipation boss 34 and the heat spreader 21 may be set to be less than 0.5 mm, so as to allow sufficient space for the elastic structure 23 and the first heat conducting material. In addition, the first heat conducting material is a soft material, and when the elastic structure 23 is compressed and stretched, the first heat conducting material can flow with the elastic structure 23, thereby preventing the first heat conducting material from affecting an elastic capability of the elastic structure 23.

Optionally, in the electronic device provided in this embodiment of this application, refer to FIG. 4. The heat spreader 21 is in contact with the element 1 through a second heat conducting material (not shown in the figure). Because the heat dissipation assembly 2 has a low requirement on adhesion strength of a heat conducting material, a heat conducting material with a good heat dissipation capability can be selected as the second heat conducting material. For example, a material of the second heat conducting material may include a silicone material, whose coefficient of heat conductivity is approximately 6 W/mK, thereby improving heat dissipation efficiency of the element 1. In addition, the material of the second heat conducting material may alternatively be another material with high heat conductivity. This is not limited herein. In addition, to avoid impact on heat conduction from the element 1 to the heat spreader 21 caused by an excessively large distance between the element 1 and the heat spreader 21, a gap between the element 1 and the heat spreader 21 may be set to be less than 0.1 mm, for example, may be set to 0.05 mm, that is, a thickness of the heat conducting material disposed between the element 1 and the heat spreader 21 is less than 0.1 mm.

In a related technology, as shown in FIG. 1, generally a chip may include a substrate 11, a die 12 fastened on the substrate 11, and a protection cover 13. The protection cover 13 is bonded to the die 12 by using a heat conducting material. In addition, the protection cover 13 is bonded to four corners or a perimeter of the chip, and therefore, the protection cover 13 occupies a layout area of a chip package.

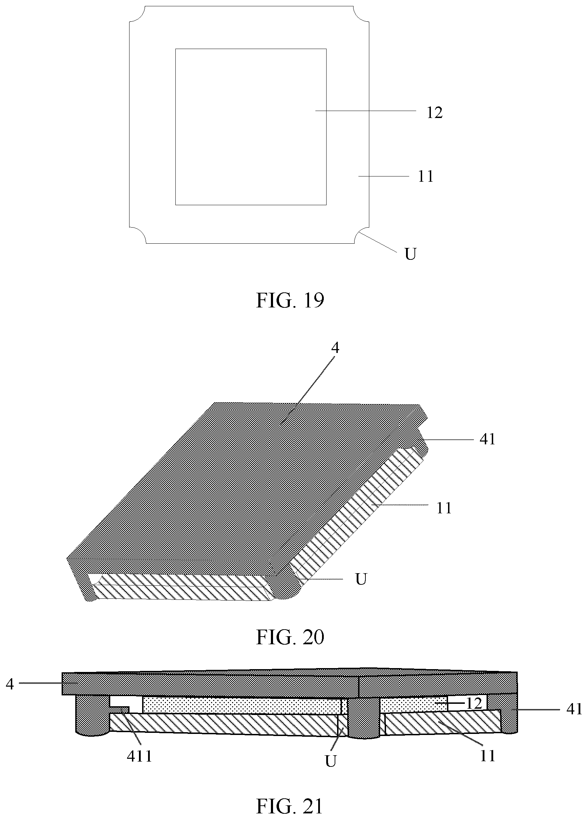

Based on this, to resolve a problem that a protection cover occupies a layout area of a chip package, an embodiment of this application provides a chip package structure. FIG. 18 is a side view of a chip package structure according to an embodiment of this application. As shown in FIG. 18, the chip package structure may include a substrate 11, a die 12 fastened on the substrate 11, and a cover plate 4. An edge of the die 12 is located within a range of an edge of the substrate 11. Optionally, the die 12 may be fastened on the substrate 11 through a second welding layer 14. FIG. 19 is a schematic plan view of a structure of a chip package structure according to an embodiment of this application. It can be clearly seen from FIG. 19 that an edge of a die 12 is located within a range of an edge of a substrate 11, that is, a size of the die 12 is less than a size of the substrate 11, so as to allow sufficient space for packaging. The die is a die, and is a small block of an integrated circuit body that is made of a semiconductor material and that is unpackaged, and a given function of the integrated circuit is implemented on this small piece of semiconductor.

FIG. 20 and FIG. 21 are schematic diagrams of a three-dimensional structure of a chip package structure according to an embodiment of this application. Refer to FIG. 20 and FIG. 21 together. A cover plate 4 is located on a side that is of a die 12 and that faces away from a substrate 11; the cover plate 4 has a supporting column 41 on a side closer to the substrate 11, and the supporting column 41 is fastened at an edge of the cover plate 4; the substrate 11 is provided with a notch U in a position corresponding to the supporting column 41; and the supporting column 41 is fixedly connected to the substrate 11 through an inner surface of the notch U. Optionally, the notch U may be disposed at four corners or a side edge of the substrate 11. This is not limited herein. The notch U may be a quarter-round hole or a half-round hole, or may be in another shape, which is not limited herein.

In the chip package structure provided in this embodiment of this application, the cover plate with the supporting column is disposed, the cover plate is provided with the notch in the position corresponding to the supporting column, and the supporting column is fixedly connected to the substrate through the inner surface of the notch. Therefore, the cover plate does not occupy an area of an element, and a layout area of an element package is increased. Experiments prove that, with the cover plate in this application, a layout area of an element can be increased by approximately 9%.

In this embodiment of this application, as shown in FIG. 18, a surface of a side that is of the supporting column 41 and that faces away from the cover plate 4 is flush with a surface of a side that is of the substrate 11 and that faces away from the cover plate 4. In this way, a gap between the die 12 and the cover plate 4 can be controlled by using the supporting column 41, so as to avoid a case that thermal resistance between the element 1 and the cover plate 4 is increased due to an excessively large gap, and avoid a case that the element 1 is squeezed due to an excessively small gap.

Optionally, refer to FIG. 21. The position that is on the substrate 11 and that corresponds to the supporting column 41 may be milled through, so as to form the notch U corresponding to the supporting column 41, and the supporting column 41 is fastened to the inner surface of the notch U by using a bonding material. Optionally, the inner surface of the notch U of the substrate 11 may have a metal layer. For example, copper plating may be disposed in the notch U of the substrate 11. Therefore, the supporting column 41 may be welded to the inner surface of the notch U through the metal layer, so that a connection between the supporting column 41 and the substrate 11 is firmer. Certainly, another bonding material may be alternatively used to fasten the supporting column 41 to the inner surface of the notch U. For example, an adhesive with strong adhesion may be used. The bonding material is not limited herein.

Further, in the chip package structure provided in this embodiment of this application, as shown in FIG. 21, the supporting column 41 has a fastening portion 411 that protrudes toward an interior, and the fastening portion 411 is in contact with a surface of a side of the substrate 11 closer to the cover plate 4. The supporting column 41 is provided with the fastening portion 411, and the fastening portion 411 is in contact with the surface of the substrate 11, so that a supporting capability of the supporting column 41 can be further enhanced, thereby ensuring that a specific gap is kept between the die 12 and the cover plate 4. In addition, in this embodiment of this application, refer to FIG. 18. Space between the die 12 and the cover plate 4 may be filled with a third heat conducting material (not shown in the figure). Heat generated by the die 12 is conducted through the third heat conducting material, thereby improving heat dissipation efficiency of the chip package structure.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising an element (1) and a heat dissipation assembly (2), the heat dissipation assembly comprising:
a heat spreader (21) in contact with the element (1);
a frame body (22), configured to limit a position of the heat spreader (21), wherein the frame body (22) surrounds a side wall of the heat spreader (21); and
an elastic structure (23), fixedly connected to the frame body (22), wherein the elastic structure (23) is located on a side that is of the heat spreader (21) and that faces away from the element (1);
the electronic device further comprising:
a bottom housing (31), an upper cover (32) fixedly connected to the bottom housing (31), and a printed circuit board (33), wherein
the printed circuit board (33) is disposed in the bottom housing (31), and the element (1) is fastened on a side that is of the printed circuit board (33) and that faces away from the bottom housing (31); and
a heat dissipation boss (34) is disposed on a side of the upper cover (32) closer to the bottom housing (31), the elastic structure (23) in the heat dissipation assembly (2) is in contact with the heat dissipation boss (34), and the elastic structure (23) is deformed;
wherein space between the heat dissipation boss (34) and the heat spreader (21) is filled with a first heat conducting material.

2. The electronic device according to claim 1, wherein at least a part of an edge of the frame body (22) bends to an edge of a surface of the heat spreader (21).

3. The electronic device according to claim 1, wherein the frame body (22) surrounds a side wall of the element (1), and is configured to be clamped to the element (1).

4. The electronic device according to claim 3, wherein an edge of a side that is of the frame body (22) and that is farther away from the heat spreader (21) is flush with a surface of the element (1).

5. The electronic device according to claim 3, wherein a protrusion structure (P) that protrudes toward an interior exists in a side wall of the frame body (22).

6. The electronic device according to claim 5, wherein the protrusion structure (P) is located on a side that is of the heat spreader (21) and that faces away from the elastic structure (23).

7. The electronic device according to claim 5, wherein protrusion structures (P) exist in at least two opposite side walls of the frame body (22).

8. The electronic device according to any one of claims 1 to 7, wherein the heat spreader (21) is in contact with the element (1) through a second heat conducting material.

9. The electronic device according to claim 8, wherein a material of the second heat conducting material comprises a silicone material.

## Patentansprüche

1. Elektronische Vorrichtung, die ein Element (1) und eine Wärmeableitungsanordnung (2) umfasst, wobei die Wärmeableitungsanordnung umfasst:
einen Wärmeverteiler (21) in einem Kontakt mit dem Element (1);
einen Rahmenkörper (22), der konfiguriert ist, um eine Position des Wärmeverteilers (21) einzugrenzen, wobei der Rahmenkörper (22) eine Seitenwand des Wärmeverteilers (21) umgibt; und
eine elastische Struktur (23), die fest mit dem Rahmenkörper (22) verbunden ist, wobei sich die elastische Struktur (23) auf einer Seite des Wärmeverteilers (21) befindet und von dem Element (1) abgewandt ist;
wobei die elektronische Vorrichtung ferner umfasst:
ein Bodengehäuse (31), eine obere Abdeckung (32), die fest mit dem Bodengehäuse (31) verbunden ist, und eine Leiterplatte (33), wobei
die Leiterplatte (33) in dem Bodengehäuse (31) angeordnet ist und wobei das Element (1) an einer Seite befestigt ist, auf der sich die Leiterplatte (33) befindet und die von dem Bodengehäuse (31) abgewandt ist; und
wobei ein Wärmeableitungsvorsprung (34) auf einer Seite der oberen Abdeckung (32) näher an dem Bodengehäuse (31) angeordnet ist, wobei die elastische Struktur (23) in der Wärmeableitungsanordnung (2) in einem Kontakt mit dem Wärmeableitungsvorsprung (34) steht und wobei die elastische Struktur (23) verformt ist;
wobei der Raum zwischen dem Wärmeableitungsvorsprung (34) und dem Wärmeverteiler (21) mit einem ersten wärmeleitenden Material gefüllt ist.

2. Elektronische Vorrichtung nach Anspruch 1, wobei mindestens ein Teil einer Kante des Rahmenkörpers (22) zu einer Kante einer Oberfläche des Wärmeverteilers (21) gebogen ist.

3. Elektronische Vorrichtung nach Anspruch 1, wobei der Rahmenkörper (22) eine Seitenwand des Elements (1) umgibt und konfiguriert ist, um an das Element (1) geklemmt zu werden.

4. Elektronische Vorrichtung nach Anspruch 3, wobei eine Kante einer Seite, an der sich der Rahmenkörper (22) befindet und die von dem Wärmeverteiler (21) weiter entfernt ist, bündig mit einer Oberfläche des Elements (1) ist.

5. Elektronische Vorrichtung nach Anspruch 3, wobei in einer Seitenwand des Rahmenkörpers (22) eine Ausbuchtungsstruktur (P) vorhanden ist, die in Richtung eines Innenraums ausgebuchtet ist.

6. Elektronische Vorrichtung nach Anspruch 5, wobei sich die Ausbuchtungsstruktur (P) auf einer Seite befindet, an der sich der Wärmeverteiler (21) befindet und die von der elastischen Struktur (23) abgewandt ist.

7. Elektronische Vorrichtung nach Anspruch 5, wobei in mindestens zwei gegenüberliegenden Seitenwänden des Rahmenkörpers (22) Ausbuchtungsstrukturen (P) vorhanden sind.

8. Elektronische Vorrichtung nach einem der Ansprüche 1 bis 7, wobei der Wärmeverteiler (21) durch ein zweites wärmeleitendes Material in einem Kontakt mit dem Element (1) steht.

9. Elektronische Vorrichtung nach Anspruch 8, wobei ein Material des zweiten wärmeleitenden Materials ein Siliciummaterial umfasst.

## Revendications

1. Dispositif électronique, comprenant un élément (1) et un ensemble de dissipation thermique (2), l'ensemble de dissipation thermique comprenant :
un dissipateur thermique (21) en contact avec l'élément (1) ;
un corps de cadre (22), configuré pour limiter une position du dissipateur thermique (21), le corps de cadre (22) entourant une paroi latérale du dissipateur thermique (21) ; et
une structure élastique (23), reliée de manière fixe au corps de cadre (22), la structure élastique (23) étant située sur un côté du dissipateur thermique (21) faisant face à l'opposé de l'élément (1) ;
le dispositif électronique comprenant en outre :
un boîtier inférieur (31), un couvercle supérieur (32) relié de manière fixe au boîtier inférieur (31), et une carte de circuit imprimé (33),
la carte de circuit imprimé (33) étant disposée dans le boîtier inférieur (31), et l'élément (1) étant attaché sur un côté de la carte de circuit imprimé (33) faisant face à l'opposé du boîtier inférieur (31) ; et
un bossage de dissipation thermique (34) étant disposé sur un côté du couvercle supérieur (32) plus près du boîtier inférieur (31), la structure élastique (23) dans l'ensemble de dissipation thermique (2) étant en contact avec le bossage de dissipation thermique (34), et la structure élastique (23) étant déformée ;
l'espace entre le bossage de dissipation thermique (34) et le dissipateur thermique (21) étant rempli d'un premier matériau thermoconducteur.

2. Dispositif électronique selon la revendication 1, au moins une partie d'un bord du corps de cadre (22) se pliant à un bord d'une surface du dissipateur thermique (21).

3. Dispositif électronique selon la revendication 1, le corps de cadre (22) entourant une paroi latérale de l'élément (1), et étant configuré pour être fixé par serrage à l'élément (1).

4. Dispositif électronique selon la revendication 3, un bord d'un côté du corps de cadre (22) le plus éloigné du dissipateur thermique (21) affleurant une surface de l'élément (1).

5. Dispositif électronique selon la revendication 3, une structure en saillie (P) qui fait saillie vers un intérieur existant dans une paroi latérale du corps de cadre (22).

6. Dispositif électronique selon la revendication 5, la structure en saillie (P) étant située sur un côté du dissipateur thermique (21) faisant face à l'opposé de la structure élastique (23).

7. Dispositif électronique selon la revendication 5, des structures en saillie (P) existant dans au moins deux parois latérales opposées du corps de cadre (22).

8. Dispositif électronique selon l'une quelconque des revendications 1 à 7, le dissipateur thermique (21) étant en contact avec l'élément (1) par l'intermédiaire d'un deuxième matériau thermoconducteur.

9. Dispositif électronique selon la revendication 8, un matériau du deuxième matériau thermoconducteur comprenant un matériau silicone.
